# EUROPEAN PATENT SPECIFICATION

(11) **EP 1 508 188 B1**
(45) Date of publication and mention of the grant of the patent: **22.11.2006**
(21) Application number: 02743044.6
(22) Date of filing: 17.05.2002
(51) Int. Cl.: H01S 3/1055, H01S 3/08

(54) **LASER CAVITY WITH VARIABLE DISPERSION ELEMENT**
LASERRESONATOR MIT VERÄNDERBAREM DISPERSIONSELEMENT
LASER A CAVITE AVEC ELEMENT DE DISPERSION VARIABLE

(43) Date of publication of application: 23.02.2005
(73) Proprietor: Agilent Technologies, Inc., Palo Alto, CA 94306 (US)
(72) Inventor: SCHWARZ, Jochen, 70567 Stuttgart (DE); KALLMANN, Ulrich, 72076 Tübingen (DE); MUELLER, Emmerich, 71134 Aidlingen (DE); NEBENDAHL, Bernd, 71254 Ditzingen (DE); STEFFENS, Wolf, 71083 Herrenberg (DE); HAISCH, Hansjoerg, 71155 Altdorf (DE)
(74) Representative: Neuerburg, Gerhard
(86) International application number: PCT/EP2002/005443
(87) International publication number: WO 2003/098756

(56) References cited:
- EP-A- 1 104 055
- US-A- 4 955 028
- US-A- 5 550 850
- US-A- 5 867 512
- PATENT ABSTRACTS OF JAPAN vol. 1999, no. 13, 30 November 1999 (1999-11-30) -& JP 11 233894 A (FURUKAWA ELECTRIC CO LTD:THE), 27 August 1999 (1999-08-27)
- PATENT ABSTRACTS OF JAPAN vol. 006, no. 006 (E-089), 14 January 1982 (1982-01-14) -& JP 56 126994 A (NEC CORP), 5 October 1981 (1981-10-05)
- PATENT ABSTRACTS OF JAPAN vol. 012, no. 397 (E-672), 21 October 1988 (1988-10-21) -& JP 63 137493 A (FUJITSU LTD), 9 June 1988 (1988-06-09)
- PATENT ABSTRACTS OF JAPAN vol. 1997, no. 08, 29 August 1997 (1997-08-29) -& JP 09 102645 A (ANRITSU CORP), 15 April 1997 (1997-04-15)
- PATENT ABSTRACTS OF JAPAN vol. 018, no. 035 (E-1494), 19 January 1994 (1994-01-19) -& JP 05 267768 A (TOSHIBA CORP), 15 October 1993 (1993-10-15)
- PATENT ABSTRACTS OF JAPAN vol. 2000, no. 06, 22 September 2000 (2000-09-22) -& JP 2000 082864 A (NIPPON TELEGR &TELEPH CORP <NTT>; TOKAI UNIV), 21 March 2000 (2000-03-21)

## Description

### BACKGROUND OF THE INVENTION

The present invention relates to tuning a laser with an external laser cavity.

In the optical communication industry there is a need for testing e.g. optical components and amplifiers with lasers at different wavelengths. For this purpose, various types of laser cavities are known.

Tunable lasers are described e.g. as the so-called Littman geometry in "Liu and Littman, Novel geometry for single-mode scanning of tunable lasers, Optical Society of America, 1981", or as the so-called Littrow geometry in EP 0 952 643 A2. Bragg-reflector type cavities are shown e.g. "A. Nahata et al., Widely Tunable Semiconductor Laser Using Dynamic Holographically-Defined Distributed Bragg Reflector, 2000 IEEE".

Other laser arrangements are disclosed e.g. in: EP-A-1104055, US-A-5,867,512, JP-A-11 233894, JP-A-56 126994, JP-A-63 137493, JP-A-09 102645, JP-A-05 267768, JP-A-2000 082864, US-A-5,550,850, and US-A-4,955,028.

### SUMMARY OF THE INVENTION

It is an object of the invention to provide improved tuning of a laser. The object is solved by the independent claims, 1 and 13. Further embodiments of the invention are disclosed in dependent claims 2-12 and 14-22.

For the sake of clarity, the terms 'vary', 'variation', 'variable', etc. as used herein are to be interpreted as an intended changing of a property.

According to the present invention a compensation for deviations, e.g. geometrical or optical deviations, is performed, e.g. non-mechanically, in the laser cavity setup to provide mode hop free tuning of the laser. Furthermore, it is possible to (e.g. non-mechanically) tune the laser according to a preferred embodiment of the invention.

The variation of the wavelength characteristic of the dispersion element is done by using a periodic structure as the dispersion element and varying the wavelength characteristic of the dispersion element by varying the periodicity of the periodic structure.

The variation of the periodicity of the periodic structure can be done by varying the length of a substrate for the periodic structure.

Alternatively or additionally, the variation of the periodicity of the periodic structure can be done by using as a material for the substrate any material having a voltage-, magnetism-, pressure-, humidity-, light- and/or temperature-sensitive length, and varying the length of the material by varying the voltage, magnetism, pressure, humidity, light and/or temperature applied to the material.

Alternatively or additionally, the variation of the periodicity of the periodic structure can also be done by using a chirped Bragg grating as the dispersion element and varying the wavelength characteristic of the dispersion element by moving the chirped Bragg grating. A chirped Bragg grating is a grating in which the period of the grating varies with position in the grating. The moving of the chirped Bragg grating can be performed by at least one of the following: translating the chirped Bragg grating, rotating the chirped Bragg grating.

Moreover, alternatively or additionally it is possible to vary the periodicity of the periodic structure by using variable electromagnetic or acoustic waves creating a periodic structure or acting on a periodic structure. The variability of the waves comprising at least one of the following: varying their wavelength, varying the angle of incidence on the variable periodic structure.

Due to deviations of real geometry with respect to perfect configuration and/or chromatic dispersion of the necessary optical components, in inventive embodiments using a geometry for continuous tenability, e.g. a Littman or Littrow geometry, a pivot point can generally only be found for a limited wavelength range. According to the present invention, corrections of these deviations or of the dispersion are made by varying the wavelength characteristic of the dispersion element in order to provide mode hop free tuning in an enlarged tuning range of the cavity.

In preferred embodiments of the inventive apparatus to perform the inventive method the shifting or rotation of the chirped Bragg grating relative to the laser beam can be driven by a piezo-electric translocating element which can precisely shift or rotate the grating.

Other preferred embodiments are shown by the dependent claims.

It is clear that the invention can be partly embodied or supported by one or more suitable software programs, which can be stored on or otherwise provided by any kind of data carrier, and which might be executed in or by any suitable data processing unit.

### BRIEF DESCRIPTION OF THE DRAWINGS

Other objects and many of the attendant advantages of the present invention will be readily appreciated and become better understood by reference to the following detailed description when considering in connection with the accompanied drawings. The components in the drawings are not necessarily to scale, emphasis instead being placed upon clearly illustrating the principles of the present invention. Features that are substantially or functionally equal or similar will be referred to with the same reference sign(s).
- Fig. 1-3: show schematic views of embodiments of the apparatus of the present invention;
- Fig. 4: shows an example of a variable grating in greater detail;
- Fig. 5-7: show schematic views of further embodiments of the apparatus of the present invention.

### DETAILED DESCRIPTION OF THE INVENTION

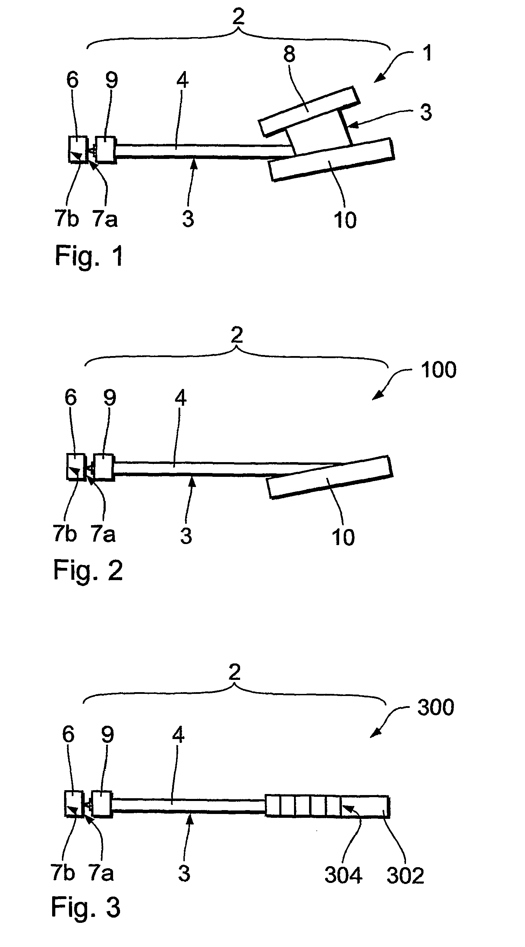

Fig. 1 shows a schematic view of a first embodiment 1 of the apparatus of the present invention. Embodiment 1 comprises an external cavity 2 in which laser light provided by an integrated laser diode 6 as an active medium can resonate to provide a laser beam 4. One side 7b of the laser diode 6 serves as a cavity end element. Beam 4 travels in the cavity 2 along a path 3 between the cavity end element 7b and a tuning element 8, both providing a high-reflective mirror. Beam 4 is focused by a lens 9 in the path 3 on the front side 7a of the laser diode 6.

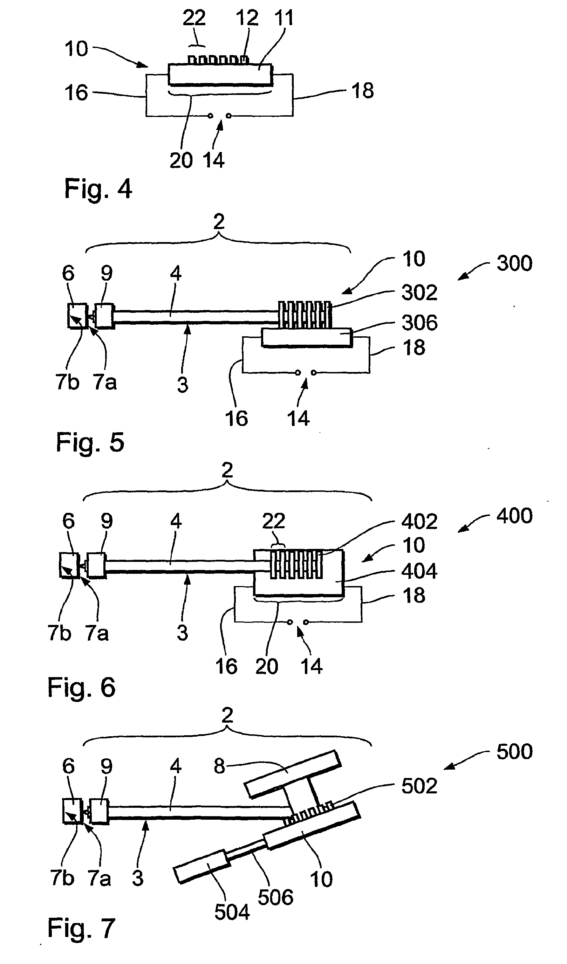

Embodiment 1 further comprises a dispersion element 10 introduced in the path 3 of the beam 4 for selecting at least one (preferably a longitudinal) mode of the laser. The dispersion element 10 comprises a variable grating 12 (see figure 4).

Embodiment 1 is configured in a Littman-type configuration. Therefore, the tuning element 8 can be rotated by an actuator (not shown) about a (not shown) pivot axis to tune the laser. The pivot axis is theoretically defined by the intersection of the optical surface planes of the cavity end element 7b of the laser diode 6, the dispersion element 10 and the tuning element 8.

The variable grating 12 of the dispersion element 10 can be varied by varying the wavelength characteristic of the grating 12, i.e. by varying the period of the grating 12. For this purpose the grating 12 is mounted on a substrate. Figure 4 shows this in greater detail.

Figure 4 shows the dispersion element 10 with the substrate 11 and the grating 12. The substrate 11 is a piezo-electric element, which can be influenced by a voltage 14 via connecting lines 16 and 18. Varying the voltage 14 will vary the length 20 of the substrate 11. Consequently, the period 22 of the grating 12 will vary accordingly. This variation of period 22 of the grating 12 can compensate a shift between a real position of the pivot axis and a theoretically by the Littman theory defined position. The variation of the grating period 22 has to be done to such an extent that the compensation is sufficient to provide continuous single-mode tuning within a predetermined tuning range of the tuning element 8.

Alternatively, the tuning itself can be done by the variation of the period 22 of the grating 12. This is also done by varying the voltage 14 and therefore the length of the substrate 11.

Alternatively, the compensation or the tuning can be done by varying the length of the substrate with other measures, e.g. with heat, pressure, light, magnetism, humidity and/or temperature.

Figure 2 shows a second embodiment 100 of the present invention. Embodiment 100 is configured in a Littrow-type configuration. Therefore, the dispersion element 10 serves also as the tuning element. Besides that the dispersion element 10 can be build up by a piezo-electric element, also. Therefore, in embodiment 100 of Figure 2 the compensation of a shift between a real position of the pivot axis of dispersion element 10 and a theoretically by the Littrow theory defined position and a tuning can both be done by the combined dispersion element 10 comprising a piezo-electric element according to Figure 4.

As an alternative to the piezo-electric element as the dispersion element 10 of embodiment 1 and 100 a variable periodic index structure can be generated in the dispersion element 10 with light or by sound (not shown). E.g. a periodic light structure exposes a material and the generated carrier density yields a periodic index structure or variable acoustic waves generated by a piezo oscillator or an acusto-optic modulator generate a periodic structure (not shown). The variation of such a periodic light or sound structure can be done by a variation of the irradiation wavelength or a variation of the irradiation angle (not shown).

Figure 3 shows a third embodiment 300 of the present invention. In embodiment 300 the cavity 2 is configured in a Bragg reflector configuration. Therefore, a Bragg reflector 302 having a variable periodic structure 304 is used. The Bragg reflector 302 can then be mounted on a piezo electric substrate 306 as shown in more detail in Figure 5. Optionally, it can be etched directly into a piezo-electric substrate (not shown).

Alternatively, as shown in a fourth embodiment 400 according to Figure 6 the Bragg reflector can be periodically diffused material 402 diffused in a piezo-electric element 404. Then by varying the length 20 of the piezo-electric element 404 the period 22 of the Bragg reflector 402 can be varied to tune the laser. Optionally, other materials can be used instead of piezo-electric material.

Figure 7 shows a fifth embodiment 500 of the present invention. Embodiment 500 is configured in a Littman-type configuration. Embodiment 500 uses a chirped Bragg grating 502 as a dispersion element 10. By moving the dispersion element 10 with a linear motor 504 connected to the dispersion element 10 by a connector 506 the chirped Bragg grating 502 can be moved and by this the above-mentioned compensation or tuning facility of the present invention is provided.

## Claims

1. A method of tuning a laser, comprising the steps of:
providing a laser beam (4) in an external cavity (2) having a dispersion element (10) for selecting at least one mode of the laser, wherein the dispersion element (10) has a periodic structure (12, 302, 304, 402), varying the wavelength characteristic of the dispersion element (10) by varying a periodicity (22) of the periodic structure (12, 302, 304, 402),
**characterized in that**
the variation of the periodicity (22) of the periodic structure (12, 302, 304, 402), is controlled to compensate for deviations between an actual and a theoretical geometry of the cavity (2) in order to avoid mode hops in a certain wavelength range, when tuning the laser.

2. The method of claim 1, wherein the step of varying the periodicity (22) of the periodic structure (12, 302, 304, 402) comprises a step of varying a length (20) of a substrate (11, 306, 404) for the periodic structure (12, 302, 304, 402).

3. The method of claim 2, wherein the step of varying the length (20) of the substrate (11, 306, 404) comprises the steps of:
using as a material for the substrate (11, 306, 404) any material having at least one of the following: a voltage-, magnetism-, pressure-, humidity-, light-, temperature-sensitive length, preferably by using as the material a piezo-electric material (11, 306, 404), and
varying the length of the material by varying at least one of the following: the voltage, magnetism, pressure, humidity, light, temperature applied to the material.

4. The method of claims 1, wherein:
the dispersion element (10) comprises a chirped Bragg grating (502), and
the step of varying the wavelength characteristic of the dispersion element (10) comprises a step of moving the Bragg grating (502).

5. The method of claim 4, wherein the step of
moving the Bragg grating (502) comprises at least one of the following steps of: translating the Bragg grating (502) relative to the laser beam (4), and rotating the Bragg grating (502) relative to the laser beam (4).

6. The method of claim 1, wherein the step of varying the periodicity (22) of the periodic structure (12, 302, 304, 402) comprises a step of using variable waves acting on the periodic structure (12, 302, 304, 402).

7. The method of claim 6, wherein the step of using variable waves comprises at least one of:
using variable electromagnetic waves, and
using variable acoustic waves.

8. The method of claim 6 or 7, wherein the variability of the waves comprises at least one of the following: varying their wavelength, varying the angle of incidence on the variable periodic structure (12, 302, 304, 402).

9. The method of claim 1 or any one of the above claims, wherein a rotating tuning element (8) is used in a cavity (2) having an optical path length (3), and the cavity (2) being of Littman or Littrow type, the method further comprising the steps of:
at least approximately evaluating a function which determines the quantity of variation of the optical path length (3) for generating mode or wavelength hop free rotating of the tuning element (8) within a predetermined tuning range of the tuning element (8) as a function of the rotation angle of the tuning element (8), by:
(a) substantially detecting mode or wavelength hops during rotation of the tuning element (8),
(b) rotating the tuning element (8) about a predetermined angle until at least one mode or wavelength hop has substantially occurred,
(c) varying the optical path length (3) by an arbitrary quantity by varying the wavelength characteristic of the dispersion element (10),
(d) rotating back the tuning element (8) about the predetermined angle of step (b),
repeating steps (a) to (d) with increasing or decreasing quantity of variation of step (c) until substantially no mode or wavelength hops during rotation of the tuning element (8) are detected in step (b),
using the quantity of variation of step (c) per rotating angle of step (b) to evaluate an approximation of the function that determines the quantity of variation of the optical path length (3) per rotating angle of the tuning element (8).

10. The method of claim 9, further comprising the step of:
varying the optical path length (3) according to the approximation function before or while rotating the tuning element (8).

11. The method of claim 10, further comprising the steps of:
measuring the quantity of variation of the variation of the optical path length (3),
comparing the measured value with the predetermined value, adjusting the quantity of variation when detecting a difference between the measured value and the predetermined value.

12. The method of claim 9 or any one of the above claims, further comprising at least one of the steps of:
modulating the variation of the optical path length (3) of the path (4), modulating the variation of the periodicity (22) of the grating (12).

13. An apparatus for tuning a laser, comprising:
an external cavity (2),
a dispersion element (10) for selecting at least one mode of the laser, the dispersion element (10) having a variable wavelength characteristic, and
a control unit adapted for varying the wavelength characteristic of the dispersion element (10),
wherein the dispersion element (10) comprises a periodic structure (12, 302, 304, 402), so that the wavelength characteristic of the dispersion element (10) is variable by varying the periodicity of the periodic structure (12,302,304,402)
**characterized in that**
the control unit is adapted for varying the periodicity (22) of the periodic structure (12, 302, 304, 402) to compensate for deviations between an actual and a theoretical geometry of the cavity (2) in order to avoid mode hops in a certain wavelength range, when tuning the laser.

14. The apparatus of claim 13, further comprising:
a substrate (11, 306, 404) for the periodic structure (12, 302, 304, 402), the substrate (11, 306, 404) having a variable length (20).

15. The apparatus of claim 14, wherein:
a material for the substrate (11, 306, 404) comprises a material having at least one of the following: a voltage-, magnetism-, pressure-, humidity-, light-, temperature-sensitive length, and
the apparatus comprises a unit for varying the length (20) of the material by varying at least one of the following: the voltage, magnetism, pressure, humidity, light, temperature applied to the material.

16. The apparatus of claims 13,
wherein the dispersion element (10) comprises a chirped Bragg grating (502), so that the wavelength characteristic of the dispersion element (10) is variable relative to the laser beam (4) by moving the Bragg grating (502).

17. The apparatus of claim 16,
wherein the wavelength characteristic of the chirped Bragg grating (502) is variable relative to the laser beam (4) by at least one of the following: translating the Bragg grating (502) relative to the laser beam (4), rotating the Bragg grating (502) relative to the laser beam (4).

18. The apparatus of claim 13, further comprising:
a piezo-electric translocating element (504) for doing at least one of the following: translating the Bragg grating (502) relative to the laser beam (4), rotating the Bragg grating (502) relative to the laser beam (4).

19. The apparatus of claim 13,
wherein the periodicity (22) of the periodic structure (12,302,304,402) is variable by variable waves acting on the periodic structure (12, 302, 304, 402).

20. The apparatus of claim 19,
wherein the periodicity (22) of the periodic structure (12, 302, 304, 402) is variable by at least one of: variable electromagnetic waves and variable acoustic waves.

21. The apparatus of claim 19 or 20, further comprising:
a varying element for varying the waves by one of the following: varying their wavelength, varying the angle of incidence on the variable periodic structure (12, 302, 304, 402).

22. The apparatus of claim 13 or any one of the above claims 14- 21,
wherein the external cavity (2) is of one of the following types: Littman, Littrow, Bragg-reflector.

## Patentansprüche

1. Verfahren zum Abstimmen eines Lasers, das die folgenden Schritte umfasst:
Bereitstellen eines Laserstrahls (4) in einem externen Resonator (2) mit einem Dispersionselement (10) zum Auswählen mindestens einer Mode des Lasers, wobei das Dispersionselement (10) eine periodische Struktur (12, 302, 304, 402) aufweist,
Variieren der spektralen Eigenschaften des Dispersionselements (10) durch Variieren der Gitterkonstanten (22) der periodischen Struktur (12, 302, 304, 402),
**dadurch gekennzeichnet, dass**
das Variieren der Gitterkonstanten (22) der periodischen Struktur (12, 302, 304, 402) so gesteuert wird, dass beim Abstimmen des Lasers die Abweichungen einer tatsächlichen von einer theoretischen Geometrie des Resonators (2) kompensiert werden, um Modensprünge in einem bestimmten Wellenlängenbereich zu vermeiden.

2. Verfahren nach Anspruch 1, bei welchem der Schritt des Variierens der Gitterkonstanten (22) der periodischen Struktur (12, 302, 304, 402) einen Schritt des Variierens einer Länge (20) eines Substrats (11, 306, 404) für die periodische Struktur (12, 302, 304, 402) umfasst.

3. Verfahren nach Anspruch 2, bei welchem der Schritt des Variierens der Länge (20) des Substrats (11, 306, 404) die folgenden Schritte umfasst:
Verwenden eines beliebigen Materials für das Substrat (11, 306, 404) mit mindestens einer der folgenden Eigenschaften: Abhängigkeit der Länge von der Spannung, vom Magnetismus, vom Druck, von der Feuchtigkeit, vom Licht und von der Temperatur, wobei als Material vorzugsweise ein piezoelektrisches Material (11, 306, 404) verwendet wird, und
Variieren der Länge des Materials durch Variieren mindestens einer der folgenden Einflussgrößen: der Spannung, des Magnetismus, des Drucks, der Feuchtigkeit, des Lichtes, der Temperatur, die auf das Material einwirken.

4. Verfahren nach Anspruch 1, bei welchem:
das Dispersionselement (10) ein Braggsches Gitter (502) mit verlaufender Gitterkonstante und
der Schritt des Variierens der spektralen Eigenschaften des Dispersionselements (10) den Schritt des Verschiebens des Braggschen Gitters (502) umfasst.

5. Verfahren nach Anspruch 4, bei welchem der Schritt des
Verschiebens des Braggschen Gitters (502) mindestens einen der folgenden Schritte umfasst: lineares Verschieben des Braggschen Gitters (502) gegenüber den Laserstrahl (4) und Drehen des Braggschen Gitters (502) gegenüber dem Laserstrahl (4).

6. Verfahren nach Anspruch 1, bei welchem der Schritt des Variierens der Gitterkonstanten (22) der periodischen Struktur (12, 302, 304, 402) einen Schritt des Verwendens auf die periodische Struktur (12, 302, 304, 402) einwirkender variabler Wellen umfasst.

7. Verfahren nach Anspruch 6, bei welchem der Schritt des Verwendens variabler Wellen zumindest einen der folgenden Schritte umfasst:
Verwenden variabler elektromagnetischer Wellen, und
Verwenden variabler akustischer Wellen.

8. Verfahren nach Anspruch 6 oder 7, bei welchem das Variieren der Wellen mindestens einen der folgenden Schritte umfasst: Variieren ihrer Wellenlänge, Variieren des Einfallswinkels auf die variable periodische Struktur 812, 302, 304, 402).

9. Verfahren nach Anspruch 1 oder einem der obigen Ansprüche, bei welchem ein drehbares Abstimmungselement (8) in einem Resonator (2) mit einer optischen Weglänge (3) verwendet wird und der Resonator (2) ein Resonator vom Littman- oder vom Littrow-Typ ist und das Verfahren ferner die folgenden Schritte umfasst:
zumindest näherungsweise Berechnung einer Funktion, welche die Änderungsgröße der optischen Weglänge (3) zum Drehen des Abstimmelements (8) innerhalb eines vorgegebenen Abstimmbereichs ohne Moden- oder Wellenlängensprünge als Funktion des Drehwinkels der Abstimmelements (8) darstellt, durch folgende Schritte:
(a) deutliches Erkennen von Moden- oder Wellenlängensprüngen während der Drehung des Abstimmelements (8),
(b) Drehen des Abstimmelements (8) um einen vorgegebenen Winkel, bis mindestens ein Moden- oder Wellenlängensprung deutlich in Erscheinung getreten ist,
(c) Variieren der optischen Weglänge (3) um einen beliebigen Betrag durch Variieren der spektralen Eigenschaften des Dispersionselements (10),
(d) Zurückdrehen des Abstimmelements (8) um den vorgegebenen Winkel von Schritt (b),
Wiederholen der Schritte (a) bis (d) mit zunehmender oder abnehmender Änderungsgröße von Schritt (c), bis während der Drehung des Abstimmelements (8) in Schritt (b) praktisch keine Moden- oder Wellenlängensprünge ermittelt werden,
Verwenden der Änderungsgröße von Schritt (c) für jeden Drehwinkel von Schritt (b), um einen Näherungswert der Funktion zu ermitteln, welche die Änderungsgröße der optischen Weglänge (3) in Abhängigkeit vom Drehwinkel des Abstimmelements (8) darstellt.

10. Verfahren nach Anspruch 9, das ferner den folgenden Schritt umfasst:
Variieren der optischen Weglänge (3) entsprechend der Näherungsfunktion vor oder während der Drehung des Abstimmelements (8).

11. Verfahren nach Anspruch 10, das ferner die folgenden Schritte umfasst:
Messen der Änderungsgröße beim Variieren der optischen Weglänge (3),
Vergleichen des Messwertes mit dem vorgegebenen Wert und Anpassen der Änderungsgröße, wenn zwischen dem Messwert und dem vorgegebenen Wert eine Differenz erkannt wurde.

12. Verfahren nach Anspruch 9 oder einem der obigen Ansprüche, das ferner mindestens einen der folgenden Schritte umfasst:
Modulieren der Änderung der optischen Weglänge (3) des optischen Weges (4), Modulieren der Änderung der Gitterkonstanten (22) des Gitters (12).

13. Vorrichtung zum Abstimmen eines Lasers, die Folgendes umfasst:
einen externen Resonator (2),
ein Dispersionselement (10) zum Auswählen mindestens einer Mode des Lasers, wobei die spektralen Eigenschaften des Dispersionselements (10) variabel sind, und
eine Steuereinheit zum Variieren der spektralen Eigenschaften des Dispersionselements (10),
wobei das Dispersionselement (10) eine periodische Struktur (12, 302, 304, 402) derart umfasst, dass die spektralen Eigenschaften des Dispersionselements (10) durch Variieren der Gitterkonstanten der periodischen Struktur (12, 302, 304, 402) variiert werden können,
**dadurch gekennzeichnet, dass**
die Steuereinheit zum Variieren der Gitterkonstanten (22) der periodischen Struktur (12, 302, 304, 402) geeignet ist, Abweichungen einer tatsächlichen von einer theoretischen Geometrie des Resonators (2) zu kompensieren, um so beim Abstimmen des Lasers Modensprünge in einem bestimmten Wellenlängenbereich zu vermeiden.

14. Vorrichtung nach Anspruch 13, die ferner Folgendes umfasst:
Ein Substrat (11, 305, 404) für die periodische Struktur (12, 302, 304, 402), wobei das Substrat (11, 305, 404) eine variable Länge (20) aufweist.

15. Vorrichtung nach Anspruch 14, bei welcher:
ein Material für das Substrat (11, 305, 404) ein Material mit mindestens einer der folgenden Eigenschaften umfasst: Abhängigkeit der Länge von der Spannung, vom Magnetismus, vom Druck, von der Feuchtigkeit, vom Licht und von der Temperatur, und
die Vorrichtung eine Einheit zum Variieren der Länge (20) des Materials durch Variieren zumindest einer der folgenden Einflussgrößen umfasst: der Spannung, des Magnetismus, des Drucks, der Feuchtigkeit, des Lichtes, der Temperatur, die auf das Material einwirken.

16. Vorrichtung nach Anspruch 13,
bei welcher das Dispersionselement (10) ein Braggsches Gitter (502) mit verlaufender Gitterkonstante derart umfasst, dass die spektralen Eigenschaften des Dispersionselements (10) bezüglich des Laserstrahls (4) durch Verschieben des Braggschen Gitters (502) variiert werden können.

17. Vorrichtung nach Anspruch 16,
bei welcher die spektralen Eigenschaften des Braggschen Gitters (502) mit verlaufender Gitterkonstante zumindest durch einen der folgenden Schritte bezüglich des Laserstrahls (4) variiert werden können: Verschieben des Braggschen Gitters (502) gegenüber dem Laserstrahl (4), Drehen des Braggschen Gitters (502) gegenüber dem Laserstrahl (4).

18. Vorrichtung nach Anspruch 13, die ferner Folgendes umfasst:
Ein piezoelektrisches Verschiebungselement (504) zum Ausführen zumindest eines der folgenden Schritte: Verschieben des Braggschen Gitters (502) gegenüber dem Laserstrahl (4), Drehen des Braggschen Gitters (502) gegenüber dem Laserstrahl (4).

19. Vorrichtung nach Anspruch 13,
bei der die Gitterkonstante (22) der periodischen Struktur (12, 302, 304, 402) durch auf die periodische Struktur (12, 302, 304, 402) einwirkende variable Wellen variiert werden kann.

20. Vorrichtung nach Anspruch 19,
bei der die Gitterkonstante (22) der periodischen Struktur (12, 302, 304, 402) durch mindestens eine der folgenden Wellen variiert werden kann: veränderliche elektromagnetische Wellen und veränderliche akustische Wellen.

21. Vorrichtung nach Anspruch 19 oder 20, die ferner Folgendes umfasst:
Ein Änderungselement zum Variieren der Wellen durch einen der folgenden Schritte: Ändern ihrer Wellenlänge, Ändern des Einfallswinkels in die variable periodische Struktur (12, 302, 304, 402).

22. Vorrichtung nach Anspruch 13 oder einem der obigen Ansprüche 14 bis 21,
bei welcher der externe Resonator (2) ein Resonator von einem der folgenden Typen ist: Littman-, Littrow- und Bragg-Reflektor.

## Revendications

1. Procédé d'accord d'un laser, comprenant les étapes consistant à :
présenter un faisceau laser (4) dans une cavité externe (2) ayant un élément de dispersion (10) pour sélectionner au moins un mode du laser, dans lequel l'élément de dispersion (10) possède une structure périodique (12, 302, 304, 402), faire varier la caractéristique de longueur d'onde de l'élément de dispersion (10) en faisant varier une périodicité (22) de la structure périodique (12, 302, 304, 402),
**caractérisé en ce que**
la variation de la périodicité (22) de la structure périodique (12, 302, 304, 402) est régulée pour compenser des écarts entre une géométrie effective et une géométrie théorique de la cavité (2) afin d'éviter des sauts de mode dans une plage de longueurs d'onde donnée, lors de l'accord du laser.

2. Procédé selon la revendication 1, dans lequel l'étape de variation de la périodicité (22) de la structure périodique (12, 302, 304, 402) comprend une étape de variation d'une longueur (20) d'un substrat (11, 306, 404) pour la structure périodique (12, 302, 304, 402).

3. Procédé selon la revendication 2, dans lequel l'étape de variation de la longueur (20) du substrat (11, 306, 404) comprend les étapes consistant à :
utiliser en tant que matériau pour le substrat (11, 306, 404) un quelconque matériau présentant au moins l'une des caractéristiques suivantes : longueur sensible à la tension, au magnétisme, à la pression, à l'humidité, à la lumière, à la température, de préférence en utilisant pour ce matériau un matériau piézo-électrique (11, 306, 404), et
faire varier la longueur du matériau en faisant varier au moins l'une des caractéristiques suivantes : tension, magnétisme, pression, humidité, lumière,
température, appliquées au matériau.

4. Procédé selon la revendication 1, dans lequel:
l'élément de dispersion (10) comprend un réseau de Bragg à pas variable (502), et
l'étape de variation de la caractéristique de longueur d'onde de l'élément de dispersion (10) comprend une étape de déplacement du réseau de Bragg (502).

5. Procédé selon la revendication 4, dans lequel l'étape de
déplacement du réseau de Bragg (502) comprend au moins l'une des actions suivantes : translation du réseau de Bragg (502) par rapport au faisceau laser (4), et rotation du réseau de Bragg (502) par rapport au faisceau laser (4).

6. Procédé selon la revendication 1, dans lequel l'étape de variation de la périodicité (22) de la structure périodique (12, 302, 304, 402) comprend une étape d'utilisation d'ondes variables agissant sur la structure périodique (12, 302, 304, 402).

7. Procédé selon la revendication 6, dans lequel l'étape d'utilisation d'ondes variables comprend au moins l'une des étapes suivantes :
l'utilisation d'ondes électromagnétiques variables, et
l'utilisation d'ondes acoustiques variables.

8. Procédé selon la revendication 6 ou 7, dans lequel la variabilité des ondes comprend au moins l'une des étapes suivantes : variation de leur longueur d'onde, variation de l'angle d'incidence sur la structure périodique variable (12, 302, 304, 402).

9. Procédé selon la revendication 1 ou l'une des revendications précédentes, dans lequel un élément d'accord rotatif (8) est utilisé dans une cavité (2) possédant un chemin optique (3), et la cavité (2) étant de type Littman ou Littrow, le procédé comprenant en outre les étapes consistant à :
évaluer au moins approximativement une fonction qui détermine la quantité de variation du chemin optique (3) pour générer une rotation sans saut de mode ou de longueur d'onde de l'élément d'accord (8) dans une plage d'accord prédéterminée de l'élément d'accord (8) en fonction de l'angle de rotation de l'élément d'accord (8), en :
(a) détectant sensiblement des sauts de mode ou de longueur d'onde pendant la rotation de l'élément d'accord (8),
(b) pivotant l'élément d'accord (8) par rapport à un angle prédéterminé jusqu'à ce que au moins un saut de mode ou de longueur d'onde se produise sensiblement,
(c) faisant varier le chemin optique (3) d'une quantité arbitraire en faisant varier la caractéristique de longueur d'onde de l'élément de dispersion (10),
(d) pivotant dans le sens inverse l'élément d'accord (8) par rapport à l'angle prédéterminé de l'étape (b),
répéter les étapes (a) à (d) avec une quantité croissante ou décroissante de variation de l'étape (c) jusqu'à ce que sensiblement aucun saut de mode ou de longueur d'onde pendant la rotation de l'élément d'accord (8) ne soit détecté à l'étape (b),
utiliser la quantité de variation de l'étape (c) par angle de rotation de l'étape (b) pour évaluer une approximation de la fonction qui détermine la quantité de variation du chemin optique (3) par angle de rotation de l'élément d'accord (8).

10. Procédé selon la revendication 9, comprenant en outre l'étape de :
variation du chemin optique (3) en fonction de la fonction d'approximation avant ou pendant la rotation de l'élément d'accord (8).

11. Procédé selon la revendication 10, comprenant en outre les étapes de :
mesure de la quantité de variation de la variation du chemin optique (3),
comparaison de la valeur mesurée à la valeur prédéterminée, ajustement de la quantité de variation lors de la détection d'une différence entre la valeur mesurée et la valeur prédéterminée.

12. Procédé selon la revendication 9 ou l'une des revendications précédentes, comprenant en outre au moins l'une des étapes de :
modulation de la variation du chemin optique (3) du chemin (4),
modulation de la variation de la périodicité (22) du réseau (12).

13. Dispositif d'accord d'un laser, comprenant :
une cavité externe (2),
un élément de dispersion (10) pour sélectionner au moins un mode du laser, l'élément de dispersion (10) possédant une caractéristique de longueur d'onde variable, et
une unité de commande adaptée pour faire varier la caractéristique de longueur d'onde de l'élément de dispersion (10),
dans lequel l'élément de dispersion (10) comprend une structure périodique (12, 302, 304, 402), de sorte que la caractéristique de longueur d'onde de l'élément de dispersion (10) est variable en faisant varier la périodicité de la structure périodique (12, 302, 304, 402) ;
**caractérisé en ce que**
l'unité de commande est adaptée pour faire varier la périodicité (22) de la structure périodique (12, 302, 304, 402) pour compenser des écarts entre une géométrie effective et une géométrie théorique de la cavité (2) afin d'éviter des sauts de mode dans une plage de longueurs d'onde donnée, lors de l'accord du laser.

14. Dispositif selon la revendication 13, comprenant en outre :
un substrat (11, 306, 404) pour la structure périodique (12, 302, 304, 402), le substrat (11, 306, 404) ayant une longueur variable (20).

15. Dispositif selon la revendication 14, dans lequel :
un matériau pour le substrat (11, 306, 404) comprend un matériau présentant au moins l'une des caractéristiques suivantes : longueur sensible à la tension, au magnétisme, à la pression, à l'humidité, à la lumière, à la température, et
le dispositif comprend une unité pour faire varier la longueur (20) du matériau en faisant varier au moins l'une des caractéristiques suivantes : tension, magnétisme, pression, humidité, lumière, température, appliquées au matériau.

16. Dispositif selon la revendication 13,
dans lequel l'élément de dispersion (10) comprend un réseau de Bragg à pas variable (502), de sorte que la caractéristique de longueur d'onde de l'élément de dispersion (10) est variable par rapport au faisceau laser (4) en déplaçant le réseau de Bragg (502).

17. Dispositif selon la revendication 16,
dans lequel la caractéristique de longueur d'onde du réseau de Bragg à pas variable (502) est variable par rapport au faisceau laser (4) par au moins l'une des actions suivantes : translation du réseau de Bragg (502) par rapport au faisceau laser (4), rotation du réseau de Bragg (502) par rapport au faisceau laser (4).

18. Dispositif selon la revendication 13, comprenant en outre :
un élément de translocation piézo-électrique (504) pour réaliser au moins l'une des actions suivantes : translation du réseau de Bragg (502) par rapport au faisceau laser (4), rotation du réseau de Bragg (502) par rapport au faisceau laser (4).

19. Dispositif selon la revendication 13,
dans lequel la périodicité (22) de la structure périodique (12, 302, 304, 402) est variable par des ondes variables agissant sur la structure périodique (12, 302, 304, 402).

20. Dispositif selon la revendication 19,
dans lequel la périodicité (22) de la structure périodique (12, 302, 304, 402) est variable par au moins l'une parmi : des ondes électromagnétiques variables et des ondes acoustiques variables.

21. Dispositif selon la revendication 19 ou 20, comprenant en outre :
un élément variable pour faire varier les ondes par au moins l'une des actions suivantes : variation de leur longueur d'onde, variation de l'angle d'incidence sur la structure périodique variable (12, 302, 304, 402).

22. Dispositif selon la revendication 13 ou l'une des revendications 14 à 21,
dans lequel la cavité externe (2) est de l'un des types suivants : Littman, Littrow, réflecteur de Bragg.
